# EUROPEAN PATENT APPLICATION

(11) **EP 4 607 802 A1**
(43) Date of publication of application: **27.08.2025**
(21) Application number: 24197761.0
(22) Date of filing: 30.08.2024
(51) Int. Cl.: H03L 7/099, H03B 5/12

(54) **VOLTAGE CONTROLLED OSCILLATOR AND PHASE LOCKED LOOP INCLUDING THEREOF**

(30) Priority: 23.02.2024 KR 20240026691
(71) Applicant: Samsung Electronics Co., Ltd., Gyeonggi-do, 16677 (KR)
(72) Inventor: JEONG, Soonyoung, Suwon-si (KR); YANG, Junhyeok, Suwon-si (KR); LIM, Dokyung, Suwon-si (KR); JANG, Dohun, Suwon-si (KR); JEONG, Chanyoung, Suwon-si (KR)
(74) Representative: Marks & Clerk LLP

(57) **Abstract**

A voltage controlled oscillator that includes a first drive transistor including a first gate terminal connected to a first output node, the first drive transistor being connected between a second output node and a ground node; a second drive transistor connected between the first output node and the ground node, the second drive transistor including a second gate terminal connected to the second output node; a first inductor connected between the first output node and the second output node; and a second inductor and a first variable capacitance circuit connected in parallel between a first coupling node and a second coupling node. The second inductor receives a control voltage and is inductively coupled to the first inductor.

## Description

### BACKGROUND

The present disclosure relates to a voltage controlled oscillator configured to generate an output clock having a frequency corresponding to a control voltage and a phase locked loop including the same.

Recently, as the frequency of clocks used in electronic devices increases, a voltage controlled oscillator that generates a high frequency clock with minimal noise is required.

A voltage controlled oscillator may generate an output clock based on a control voltage. For example, the voltage controlled oscillator may include an inductance tank circuit and a capacitance tank circuit. The voltage controlled oscillator may adjust the frequency of the output clock by adjusting capacitance of a varactor (e.g. a varactor diode, or variable capacitance diode) included in the capacitance tank circuit.

However, if the voltage controlled oscillator is configured to adjust the frequency of the output clock based on the varactor, the output clock may contain significant noise due to a characteristic of the varactor and circuit configuration of the voltage controlled oscillator.

### SUMMARY

Some example embodiments of the present disclosure provide for solving the above described technical problems. For example, some example embodiments provide a voltage controlled oscillator that generates a high frequency output clock in which noise is reduced (and/or minimized) and a phase locked loop that includes it.

Some example embodiments of the present disclosure provide a voltage controlled oscillator that includes a first drive transistor including a first gate terminal connected to a first output node, the first drive transistor being connected between a second output node and a ground node; a second drive transistor connected between the first output node and the ground node, the second drive transistor including a second gate terminal connected to the second output node; a first inductor connected between the first output node and the second output node; a second inductor connected in parallel between a first coupling node and a second coupling node; and a first variable capacitance circuit connected in parallel between the first coupling node and the second coupling node. The second inductor receives a control voltage and is inductively coupled to the first inductor.

Some example embodiments of the present disclosure further provide a voltage controlled oscillator that receives a control voltage and outputs first and second output clocks having frequency corresponding to a magnitude of the control voltage. The voltage controlled oscillator includes a first drive transistor including a first gate terminal connected to a first output node through which the first output clock is output, the first drive transistor being connected between a second output node and a ground node; a second drive transistor connected between the first output node and the ground node, the second drive transistor including a second gate terminal connected to the second output node through which the second output clock is output; an inductance tank circuit connected between the first output node and the second output node; and a capacitance tank circuit that is inductively coupled to the inductance tank circuit, the capacitance tank circuit operating based on a control voltage that is externally provided.

Some example embodiments of the present disclosure still further provide a phase locked loop that includes a voltage controlled oscillator that generates a first output clock and a second output clock based on a control voltage; a frequency divider that generates a feedback clock based on the first output clock and the second output clock; a phase frequency detector that generates a difference signal based on a difference between the feedback clock and a reference clock that is externally provided; and a control voltage generator that adjusts a level of the control voltage based on the difference signal. The voltage controlled oscillator includes a first inductor connected between a first output node outputting the first output clock and a second output node outputting the second output clock; a second inductor connected between a first coupling node and a second coupling node, the first coupling node and the second coupling node are electrically separated from the first and second output nodes, and the second inductor receiving the control voltage and being inductively coupled to the first inductor; a first varactor connected between the first coupling node and a first intermediate node receiving a first bias voltage; and a second varactor connected between the second coupling node and the first intermediate node.

At least some of the above and other features of the invention are set out in the claims.

### BRIEF DESCRIPTION OF THE DRAWINGS

FIG. 1 is a block diagram illustrating a phase locked loop according to some example embodiments of the present disclosure.
FIG. 2 is a graph showing quality factor of the capacitance tank circuit and the inductance tank circuit of FIG. 1.
FIG. 3 is a circuit diagram illustrating the voltage controlled oscillator of FIG. 1 implemented according to some example embodiments.
FIG. 4 is a circuit diagram illustrating a capacitance tank circuit of FIG. 3 implemented according to some example embodiments.
FIG. 5 is a circuit diagram illustrating a capacitance tank circuit of FIG. 2 implemented according to some example embodiments.
FIG. 6 is a circuit diagram illustrating the voltage controlled oscillator of FIG. 1 implemented according to some example embodiments of the present disclosure.
FIG. 7 is a circuit diagram illustrating a configuration of the voltage controlled oscillator of FIG. 6 according to some example embodiments.
FIG. 8 illustrates frequency components included in an output clock generated from the voltage controlled oscillator of FIG. 1.
FIG. 9 is a graph illustrating a relationship between capacitance and a control voltage with respect to a variable capacitance circuit according to a bias voltage of FIG. 7.
FIG. 10 is a circuit diagram illustrating a configuration of the voltage controlled oscillator of FIG. 6 implemented according to some example embodiments.
FIG. 11 is a graph illustrating a relationship between the capacitance of each of a plurality of variable capacitance circuits of FIG. 10 and the capacitance of a capacitance tank circuit.
FIG. 12 and FIG. 13 are circuit diagrams illustrating a variable capacitance circuit of FIG. 7 or FIG. 10 according to some example embodiments in more detail.
FIG. 14 is a diagram illustrating a relationship between capacitance and a control voltage of variable capacitance circuits of FIGS. 12 and 13.
FIG. 15 illustrates a voltage controlled oscillator of FIG. 1 implemented according to some example embodiments.
FIG. 16 illustrates a voltage controlled oscillator of FIG. 1 implemented according to some example embodiments.

### DETAILED DESCRIPTION

Hereinafter, some example embodiments of the present disclosure will be described clearly and in detail so that those of ordinary skill in the art can easily implement the present disclosure. Details such as configurations and structures are provided simply to aid in the overall understanding of some example embodiments of the present disclosure. Therefore, variations of some example embodiments described herein without departing from the technical scope of the present disclosure may be performed by one of ordinary skill in the art. Moreover, descriptions of well-known functions and structures are omitted for clarity and brevity. The components in the following drawings or detailed descriptions may be connected to others other than the components shown in the drawings or described in the detailed description. The terms used in the text are terms defined in consideration of the functions of the present disclosure and are not limited to specific functions. The definition of terms may be determined based on the matters described in the detailed description.

The components described with reference to terms such as a driver or block used in the detailed description may be implemented in the form of software, hardware, or a combination thereof. For example, the software may be machine code, firmware, embedded code, and application software. For example, hardware may include an electrical circuit, an electronic circuit, a processor, a computer, an integrated circuit core, a pressure sensor, an inertial sensors, MEMS (Micro Electro Mechanical System), a passive device, or a combination thereof.

Also, for example, "at least one of A, B, and C" and similar language (e.g., "at least one selected from the group consisting of A, B, and C") may be construed as A only, B only, C only, or any combination of two or more of A, B, and C, such as, for instance, ABC, AB, BC, and AC.

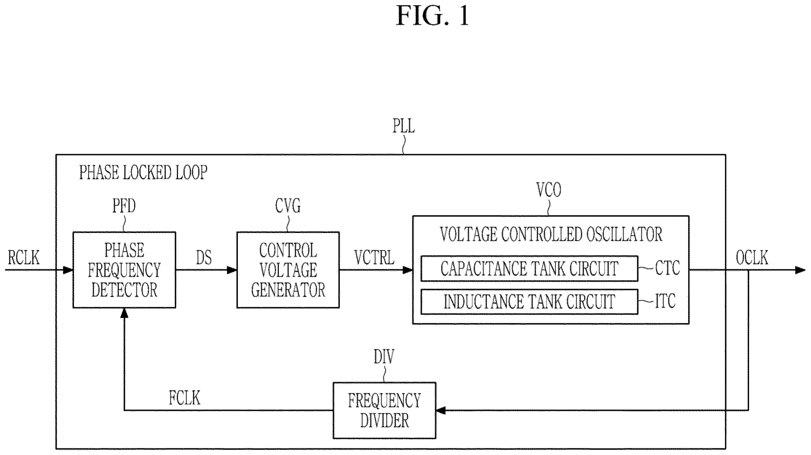

FIG. 1 is a block diagram illustrating a phase locked loop according to some example embodiments of the present disclosure. Referring to FIG. 1, a phase locked loop PLL may include a phase frequency detector PFD, a control voltage generator CVG, a voltage controlled oscillator VCO, and a frequency divider DIV.

The voltage controlled oscillator VCO may include a capacitance tank circuit CTC and an inductance tank circuit ITC. The voltage controlled oscillator VCO may receive a control voltage VCTRL. The voltage controlled oscillator VCO may generate an output clock OCLK having a frequency corresponding to the voltage level of the control voltage VCTRL by adjusting capacitance of the capacitance tank circuit CTC and/or inductance of the inductance tank circuit ITC based on the control voltage VCTRL. That is, the voltage controlled oscillator VCO may be implemented as an inductance-capacitance based voltage controlled oscillator (LC-VCO). A configuration of the voltage controlled oscillator VCO will be described with reference to the following drawings.

In some example embodiments, a frequency of the output clock OCLK may be determined as a resonance frequency for the voltage controlled oscillator VCO. The resonance frequency for the voltage controlled oscillator VCO may be determined based on the inductance of the inductance tank circuit ITC and the capacitance of the capacitance tank circuit CTC. In this way, the frequency of the output clock OCLK may change based on the change in the inductance of the inductance tank circuit ITC and/or the capacitance of the capacitance tank circuit CTC based on the voltage level of the control voltage VCTRL.

The magnitude of the phase noise included in the output clock OCLK may be determined based on a quality factor of the voltage controlled oscillator VCO. For example, the higher the quality factor of the voltage controlled oscillator VCO, the smaller the magnitude of the phase noise included in the output clock OCLK may be. On the contrary, the smaller the quality factor of the voltage controlled oscillator VCO, the larger the magnitude of the phase noise included in the output clock OCLK may be.

The magnitude of phase noise included in the output clock OCLK may be calculated and/or determined based on various equations such as 'Leeson's equation'. However, the scope of the present disclosure is not limited to a specific method in which the magnitude of the phase noise included in the output clock OCLK is calculated and/or determined.

The quality factor of the voltage controlled oscillator VCO may be determined based on quality factors of the inductance tank circuit ITC and the capacitance tank circuit CTC. For example, the quality factor for the voltage controlled oscillator VCO may be determined by 'harmonic mean' of the quality factor of the inductance tank circuit ITC and the quality factor of the capacitance tank circuit CTC. Therefore, the higher the quality factor of the inductance tank circuit ITC and the quality factor of the capacitance tank circuit CTC, the smaller the phase noise of the output clock OCLK may be.

In some example embodiments, the quality factor for any circuit may be defined based on the ratio of the energy stored in the circuit to the energy lost during one cycle of the output clock OCLK. For example, the quality factor of the inductance tank circuit ITC may be defined based on the ratio of the total energy stored in the inductance tank circuit ITC to the energy lost during one cycle of the output clock OCLK from the inductance tank circuit ITC. Similarly, the quality factor of the capacitance tank circuit CTC may be defined based on the ratio of the total energy stored in the capacitance tank circuit CTC to the energy lost during one cycle of the output clock OCLK from the capacitance tank circuit CTC. However, the scope of the present disclosure is not limited thereto.

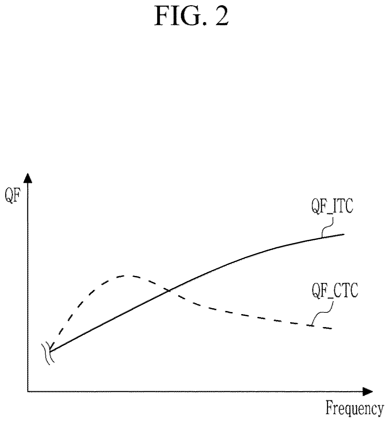

The quality factor of the inductance tank circuit ITC and the quality factor of the capacitance tank circuit CTC may vary depending on the frequency of the output clock OCLK. The quality factor of the inductance tank circuit ITC and the quality factor of the capacitance tank circuit CTC with respect to the output clock OCLK will be described in more detail with reference to FIG. 2 below.

The frequency divider DIV may receive the output clock OCLK. The frequency divider DIV may generate a feedback clock FCLK by performing frequency dividing for the output clock OCLK. For example, a frequency of the feedback clock FCLK may be lower than a frequency of the output clock OCLK.

In some example embodiments, the frequency divider DIV may adjust a frequency dividing ratio in response to (e.g., based on) a control signal (not shown) provided from the outside of the phase locked loop PLL. For example, the frequency divider DIV may increase or decrease the frequency of the feedback clock FCLK in response to a control signal (not shown) provided from outside the phase locked loop PLL.

The phase frequency detector PFD may receive a feedback clock FCLK and a reference clock RCLK. The phase frequency detector PFD may generate a difference signal DS based on a difference between a feedback clock FCLK and a reference clock RCLK.

In some example embodiments, the reference clock RCLK may be provided from an oscillator outside the phase locked loop PLL. For example, the reference clock RCLK may be provided from a crystal oscillator outside the phase locked loop PLL. However, the scope of the present disclosure is not limited to the specific type of oscillator that generates the reference clock RCLK.

In some example embodiments, a frequency of the reference clock RCLK may be lower than a frequency of the output clock OCLK.

The control voltage generator CVG may generate a control voltage VCTRL based on the difference signal DS. That is, the control voltage generator CVG may adjust the voltage level of the control voltage VCTRL based on the difference signal DS. For example, the voltage controlled oscillator VCO may generate an output clock OCLK having a changed frequency in response to the adjusted control voltage VCTRL. In this way, the voltage level of the control voltage VCTRL may be adjusted until the output clock OCLK has the intended frequency.

In some example embodiments, even if the control voltage generator CVG provides the control voltage VCTRL which allows the voltage controlled oscillator VCO to generate an intended frequency, various types of noise may be included in the output clock OCLK generated by the voltage controlled oscillator VCO. For example, the output clock OCLK may include various types of noise such as thermal noise and phase noise caused by circuit elements for controlling the inductance of the inductance tank circuit ITC or capacitance of the capacitance tank circuit CTC. For example, jitter may occur in the output clock OCLK based on the magnitude of noise included in the output clock OCLK.

FIG. 2 is a graph showing quality factor of the capacitance tank circuit and the inductance tank circuit of FIG. 1. Referring to FIG. 1 and FIG. 2, the quality factor QF_CTC for the capacitance tank circuit CTC and the quality factor OF _ITC for the inductance tank circuit ITC may vary according to the frequency of the output clock OCLK. The horizontal axis of FIG. 2 represents frequency, and the vertical axis represents quality factor QF. The quality factor QF_CTC for the capacitance tank circuit CTC is shown by a dashed line, and the quality factor OF _ITC for the inductance tank circuit ITC is shown by a solid line.

When the frequency of the output clock OCLK is greater than or equal to a specific value, the slope of the quality factor QF_CTC with respect to the frequency of the output clock OCLK may be negative. For example, as the frequency of the output clock OCLK increases, the quality factor QF_CTC may decrease. That is, as the frequency of the output clock OCLK increases, the quality factor of the voltage controlled oscillator VCO may decrease due to the quality factor QF_CTC, and accordingly, larger phase noise may be included in the output clock OCLK.

That is, when the voltage controlled oscillator VCO is implemented as inductance-capacitance based voltage controlled oscillator (LC-VCO), the output clock OCLK having high frequency may include large phase noise due to the capacitance tank circuit CTC.

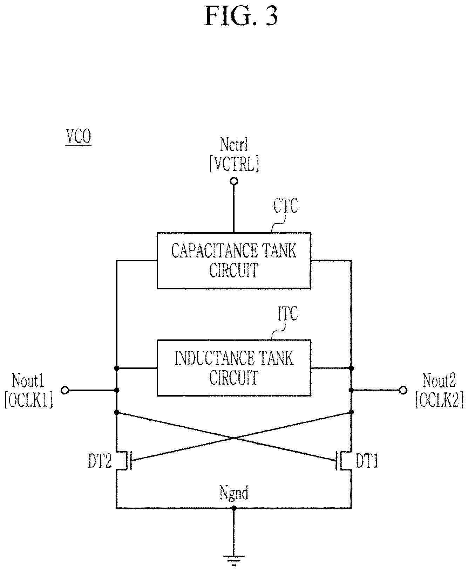

FIG. 3 is a circuit diagram illustrating the voltage controlled oscillator of FIG. 1 implemented according to some example embodiments. Referring to FIGS. 1 to 3, the voltage controlled oscillator VCO may include first and second drive transistors DT1 and DT2, an inductance tank circuit ITC, and a capacitance tank circuit CTC.

The first drive transistor DT1 may be connected between a second output node Nout2 and a ground node Ngnd. The gate terminal of the first drive transistor DT1 may be connected to a first output node Nout1.

The second drive transistor DT2 may be connected between the first output node Nout1 and the ground node Ngnd. The gate terminal of the second drive transistor DT2 may be connected to the second output node Nout2.

Hereinafter, for a more concise description, it is assumed that the first and second drive transistors DT1 and DT2 are N-type metal oxide semiconductors (NMOS). However, the scope of the present disclosure is not limited to the specific types of the first and second drive transistors DT1 and DT2. For example, one or more of the first and second drive transistors DT1 and DT2 may be implemented as a P-type metal oxide semiconductor (PMOS).

The inductance tank circuit ITC may be connected between the first output node Nout1 and the second output node Nout2. Hereinafter, for a more concise description, it is assumed that the inductance of the inductance tank circuit ITC is fixed. However, the scope of the present disclosure is not limited thereto. For example, the inductance of the inductance tank circuit ITC may be implemented as variable.

The capacitance tank circuit CTC may be connected between the first output node Nout1 and the second output node Nout2. The capacitance tank circuit CTC may be connected in parallel with the inductance tank circuit ITC.

The capacitance tank circuit CTC may be connected to the control node Nctrl. The capacitance tank circuit CTC may receive the control voltage VCTRL through the control node Nctrl. The capacitance tank circuit CTC may operate based on the control voltage VCTRL. For example, the capacitance of the capacitance tank circuit CTC may vary based on the control voltage VCTRL.

The output clock OCLK may include at least one of a first output clock OCLK1 and a second output clock OCLK2.

The first output node Nout1 may output the first output clock OCLK1. The second output node Nout2 may output the second output clock OCLK2. The phases of the first output clock OCLK1 and the second output clock OCLK2 may be opposite to each other (e.g. 180° to each other). The frequencies of first output clock OCLK1 and second output clock OCLK2 may be the same. For example, the frequencies of the first output clock OCLK1 and the second output clock OCLK2 may be resonance frequency with respect to the voltage controlled oscillator VCO.

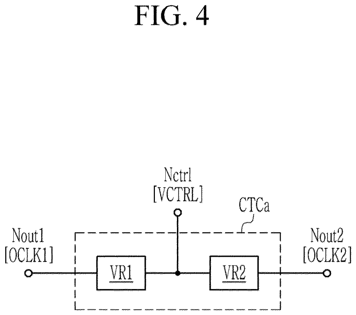

FIG. 4 is a circuit diagram illustrating a capacitance tank circuit of FIG. 3 implemented according to some example embodiments. Referring to FIGS. 1 to 4, the capacitance tank circuit CTC may be implemented as a capacitance tank circuit CTCa.

The capacitance tank circuit CTCa may include a first varactor VR1 and a second varactor VR2. The first varactor VR1 may be connected between the first output node Nout1 and the control node Nctrl. The second varactor VR2 may be connected between the second output node Nout2 and the control node Nctrl. The control node Nctrl may receive the control voltage VCTRL.

The capacitance of the capacitance tank circuit CTCa may be determined based on the capacitance of the first varactor VR1 and the second varactor VR2. The capacitance of the first varactor VR1 may be determined based on a voltage difference between both terminals of the first varactor VR1, and the capacitance of the second varactor VR2 may be determined based on a voltage difference between both terminals of the second varactor VR2. The voltage levels of the first output node Nout1 and the second output node Nout2 may be difficult to adjust. For example, the capacitance of the capacitance tank circuit CTCa may be determined based on the control voltage VCTRL.

However, the maximum variation range of the control voltage VCTRL may be limited. For example, the voltage level variation of the control voltage VCTRL may be limited. For example, the capacitance variation range of the capacitance tank circuit CTCa may be limited, and accordingly, the frequency variation range of the output clock OCLK (e.g., the first output clock OCLK1 and the second output clock OCLK2) may be limited. For example, when the capacitance of the capacitance tank circuit CTCa is controlled only based on the control voltage VCTRL, a frequency variation range of the output clock OCLK may be limited.

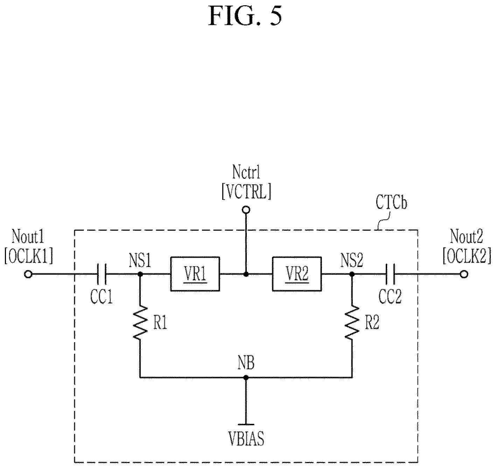

FIG. 5 is a circuit diagram illustrating a capacitance tank circuit of FIG. 2 implemented according to some example embodiments. Referring to FIGS. 1 to 5, the capacitance tank circuit CTC may be implemented as a capacitance tank circuit CTCb.

The capacitance tank circuit CTCb may include a first cut-off capacitor CC1, a second cut-off capacitor CC2, a first resistor R1, a second resistor R2, a first varactor VR1, and a second varactor VR2.

The first varactor VR1 may be connected between a first separation node NS1 and the control node Nctrl. The second varactor VR2 may be connected between a second separation node NS2 and the control node Nctrl. The control node Nctrl may receive the control voltage VCTRL.

The first cut-off capacitor CC1 may be connected between the first output node Nout1 and the first separation node NS1. The second cut-off capacitor CC2 may be connected between the second output node Nout2 and the second separation node NS2. That is, the first cut-off capacitor CC1 may electrically separate the first output node Nout1 from the first separation node NS1, and the second cut-off capacitor CC2 may electrically separate the second output node Nout2 from the second separation node NS2.

The first resistor R1 may be connected between a bias node NB and the first separation node NS1. The second resistor R2 may be connected between the bias node NB and the second separation node NS2. The bias node NB may receive a bias voltage VBIAS.

The capacitance of the first varactor VR1 may be determined based on a voltage difference between the first separation node NS1 and the control node Nctrl, and the capacitance of the second varactor VR2 may be determined based on a voltage difference between the second separation node NS2 and the control node Nctrl. Voltage levels of the first separation node NS1 and the second separation node NS2 may be determined based on the bias voltage VBIAS. A voltage level of the control node Nctrl may be determined based on the control voltage VCTRL. For example, capacitance of the first varactor VR1 and the second varactor VR2 may be determined based on the bias voltage VBIAS as well as the control voltage VCTRL. Accordingly, compared to the first varactor VR1 and the second varactor VR2 included in the capacitance tank circuit CTCa, the capacitance variation range of the first varactor VR1 and the second varactor VR2 included in the capacitance tank circuit CTCb may be relatively large.

However, the capacitance of the capacitance tank circuit CTCb may be determined based on the capacitances of the first cut-off capacitor CC1, the second cut-off capacitor CC2, the first varactor VR1, and the second varactor VR2. For example, due to the first cut-off capacitor CC1 and the second cut-off capacitor CC2, even if the capacitance of the first varactor VR1 and the second varactor VR2 is changed, the capacitance of the capacitance tank circuit CTCb may be relatively slightly changed. That is, due to the presence of the first and second cut-off capacitors CC1 and CC2, any change to the capacitance of the first and second varactors VR1 and VR2 will have a reduced effect on the overall capacitance of the capacitance tank circuit CTCb. Accordingly, due to the first cut-off capacitor CC1 and the second cut-off capacitor CC2, a frequency variation range of the output clock OCLK may be limited.

Unlike the capacitance tank circuit CTCa, the capacitance tank circuit CTCb may further include the first resistor R1 and the second resistor R2. For example, thermal noise may be included in the output clock OCLK due to the first resistor R1 and the second resistor R2.

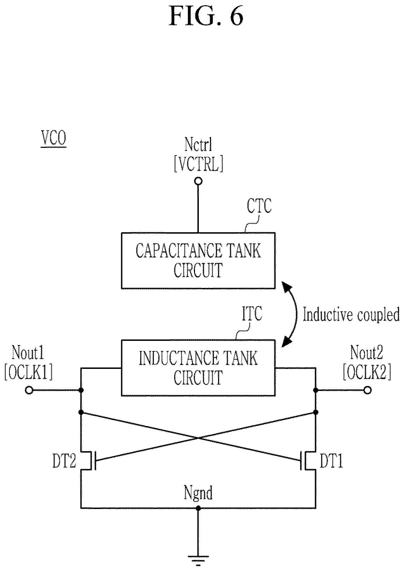

FIG. 6 is a circuit diagram illustrating the voltage controlled oscillator of FIG. 1 implemented according to some example embodiments of the present disclosure. Referring to FIG. 1, FIG. 2, and FIG. 6, the voltage controlled oscillator VCO may include first and second drive transistors DT1 and DT2, an inductance tank circuit ITC, and a capacitance tank circuit CTC. The configurations and operations of the first and second drive transistors DT1 and DT2 and the inductance tank circuit ITC are similar to those described with reference to FIG. 3, and thus a detailed description thereof will be omitted.

The capacitance tank circuit CTC may be connected to the control node Nctrl. The capacitance tank circuit CTC may receive the control voltage VCTRL through the control node Nctrl. The capacitance tank circuit CTC may be operated based on the control voltage VCTRL. For example, the capacitance of the capacitance tank circuit CTC may vary based on the control voltage VCTRL.

The capacitance tank circuit CTC may be electrically separated from the first output node Nout1 and the second output node Nout2. For example, the capacitance tank circuit CTC may be inductively coupled to the inductance tank circuit ITC. That is, instead of being directly electrically connected to the first output node Nout1 and the second output node Nout2, the capacitance tank circuit CTC may be indirectly connected by inductive coupling scheme.

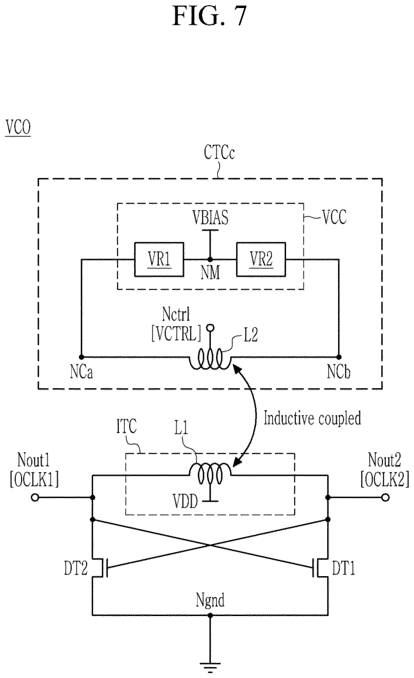

When the capacitance tank circuit CTC is indirectly connected to the first output node Nout1 and the second output node Nout2 through inductive coupling, noise components provided from the capacitance tank circuit CTC to the first and second output nodes Nout1 and Nout2 may be attenuated. For example, when the capacitance tank circuit CTC is indirectly connected to the first output node Nout1 and the second output node Nout2 through inductive coupling, the impact of low quality factor QF_CTC of the capacitance tank circuit CTC that occurs when the output clock OCLK is high frequency may be reduced (and/or minimized). Therefore, according to some example embodiments of the present disclosure, phase noise included in the output clock OCLK may be reduced (and/or minimized), and accordingly, jitter of the output clock OCLK may be reduced (and/or minimized). A method of indirectly connecting the capacitance tank circuit CTC to the first output node Nout1 and the second output node Nout2 through inductive coupling will be described in more detail with reference to FIG. 7 below.

In some example embodiments, the inductive coupling coefficient of the capacitance tank circuit CTC and the inductance tank circuit ITC may be 'k'. For example, a ratio of the frequency control amount of the output clock OCLK to the control voltage VCTRL may be determined based on the inductive coupling coefficient 'k'. However, the scope of the present disclosure is not limited thereto.

FIG. 7 is a circuit diagram illustrating a configuration of the voltage controlled oscillator of FIG. 6 implemented according to some example embodiments. Referring to FIG. 1, FIG. 2, FIG. 6 and FIG. 7, the voltage controlled oscillator VCO may include first and second drive transistors DT1 and DT2, an inductance tank circuit ITC, and a capacitance tank circuit CTC. The capacitance tank circuit CTC may be implemented as a capacitance tank circuit CTCc. Since the configurations and operations of the first and second drive transistors DT1 and DT2 are similar to those described above, a detailed description thereof will be omitted.

The inductance tank circuit ITC may include a first inductor L1. The first inductor L1 may be connected between the first output node Nout1 and the second output node Nout2.

In some example embodiments, the first inductor L1 may include a first center tap node. As shown in FIG. 7, the first center tap node may be connected to the power supply voltage VDD. For example, since power may be stably provided to the first and second drive transistors DT1 and DT2, the voltage controlled oscillator VCO may be more stably oscillated. However, the scope of the present disclosure is not limited thereto.

The capacitance tank circuit CTCc may include a second inductor L2 and a variable capacitance circuit VCC. The second inductor L2 may be connected between a first coupling node NCa and a second coupling node NCb. The variable capacitance circuit VCC may be connected between the first coupling node NCa and the second coupling node NCb. That is, the second inductor L2 and the variable capacitance circuit VCC may be connected in parallel between the first coupling node NCa and the second coupling node NCb.

In some example embodiments, the first coupling node NCa and the second coupling node NCb may be electrically separated from the first output node Nout1 and the second output node Nout2.

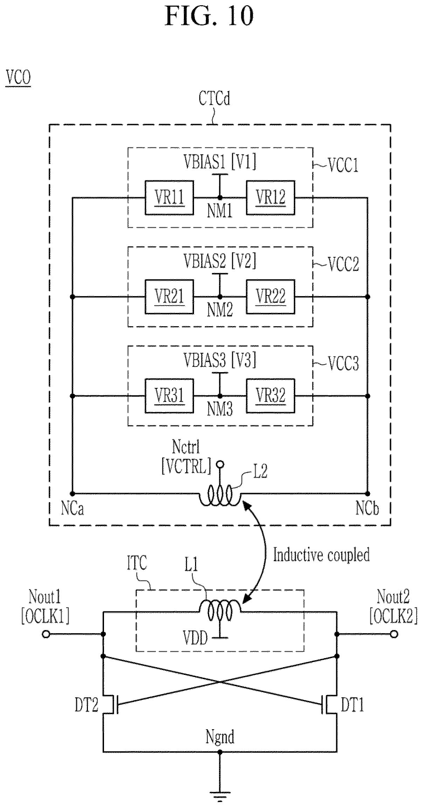

In some example embodiments, the capacitance tank circuit CTC may include a plurality of variable capacitance circuits VCC. For example, the second inductor L2 and a plurality of variable capacitance circuits VCC may be connected in parallel between the first coupling node NCa and the second coupling node NCb. Some example embodiments in which the capacitance tank circuit CTC includes a plurality of variable capacitance circuits VCC will be described in more detail with reference to FIG. 10.

The second inductor L2 may include a second center tap node connected to the control node Nctrl. That is, the second inductor L2 may receive the control voltage VCTRL through the second center tap node. For example, the voltage levels of the first coupling node NCa and the second coupling node NCb may be determined based on the voltage level of the control voltage VCTRL.

The variable capacitance circuit VCC may include a first varactor VR1 and a second varactor VR2. Hereinafter, for a more concise description, it is assumed that the first varactor VR1 and the second varactor VR2 are implemented with a varactor diode. However, the scope of the present disclosure is not limited thereto.

The first varactor VR1 may be connected between the first coupling node NCa and an intermediate node NM. The second varactor VR2 may be connected between the second coupling node NCb and the intermediate node NM. The intermediate node NM may receive the bias voltage VBIAS.

The capacitance of the first varactor VR1 may be determined based on the voltage difference between the first coupling node NCa and the intermediate node NM, and the capacitance of the second varactor VR2 may be determined based on the voltage difference between the second coupling node NCb and the intermediate node NM. That is, the capacitances of the first varactor VR1 and the second varactor VR2 may be determined based on both of the control voltage VCTRL and the bias voltage VBIAS. For example, the capacitance of the variable capacitance circuit VCC may be adjusted based on both of the control voltage VCTRL and the bias voltage VBIAS. Therefore, unlike the capacitance tank circuit CTCb described above with reference to FIG. 5, the capacitance of the capacitance tank circuit CTCc may be adjusted based on both the control voltage VCTRL and the bias voltage VBIAS even if the first and second resistors R1 and R2 and the first and second cut-off capacitors CC1 and CC2 are not included.

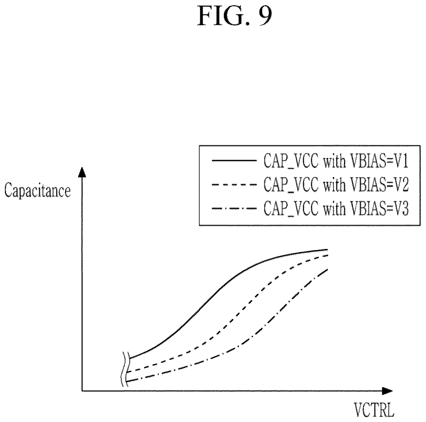

In some example embodiments, the relationship between the control voltage VCTRL and the capacitance of the variable capacitance circuit VCC may vary depending on the voltage level of the bias voltage VBIAS. The relationship between the control voltage VCTRL and the capacitance of the variable capacitance circuit VCC according to the voltage level of the bias voltage VBIAS will be described in more detail with reference to FIG. 9.

Similar to what was previously described with reference to FIG. 6, since the capacitance tank circuit CTC is indirectly connected to the first output node Nout1 and the second output node Nout2 through inductive coupling, the influence of the low quality factor QF_CTC that occurs when the output clock OCLK is high frequency may be reduced (and/or minimized).

Therefore, according to some example embodiments of the present disclosure, since the capacitance of the first varactor VR1 and the second varactor VR2 is adjusted based on both the control voltage VCTRL and the bias voltage VBIAS, the capacitance variation range of the capacitance tank circuit CTCc according to the change in the voltage level of the control voltage VCTRL may be increased (and/or maximized); and since the capacitance tank circuit CTCc does not include the first resistor R1 and the second resistor R2, thermal noise of the output clock OCLK may be reduced (and/or minimized). Since the capacitance tank circuit CTC is indirectly connected to the first output node Nout1 and the second output node Nout2 through inductive coupling, the phase noise included in the output clock OCLK may be reduced (and/or minimized).

That is, according to some example embodiments of the present disclosure, the noise of the output clock OCLK may be reduced (and/or minimized), and the limitation of the frequency variation range of the output clock OCLK due to the change in the voltage level of the control voltage VCTRL may be overcome.

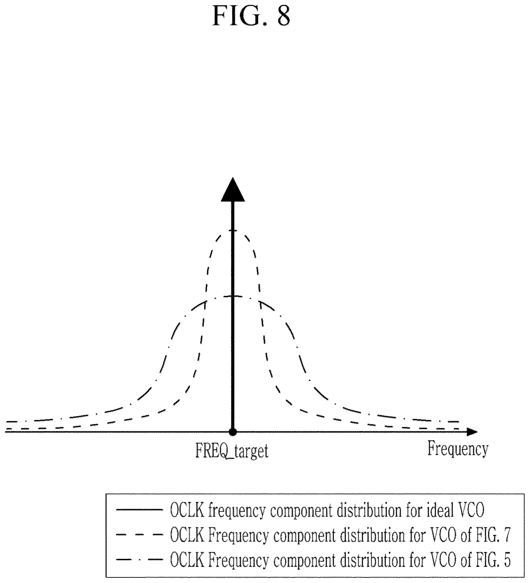

FIG. 8 illustrates frequency components included in an output clock generated from the voltage controlled oscillator of FIG. 1. Hereinafter, the frequency component distribution of the output clock OCLK generated from each of the voltage controlled oscillator VCO described above with reference to FIG. 5 and the voltage controlled oscillators VCO described above with reference to FIG. 7 will be explained. The horizontal axis of FIG. 8 represents frequency, and the vertical axis represents an amount of frequency components.

As shown by the thick solid line (located directly over the vertical axis), the output clock OCLK generated by the ideal voltage controlled oscillator VCO may have only a target frequency FREQ_target component. That is, the output clock OCLK generated by the ideal voltage controlled oscillator VCO may not include a frequency component other than the target frequency FREQ_target component determined based on the capacitance of the capacitance tank circuit CTC and the inductance of the inductance tank circuit ITC.

However, as shown by the single-dotted line, the output clock OCLK generated by the voltage controlled oscillator VCO described above with reference to FIG. 5 may include various frequency components other than the target frequency FREQ_target component. For example, the output clock OCLK may include various phase noises, and accordingly, the frequency component distribution of the output clock OCLK may have a relatively large variance. For example, the output clock OCLK generated by the voltage controlled oscillator VCO may include a relatively small amount of frequency component corresponding to the target frequency FREQ_target, and may include a relatively large amount of frequency components not corresponding to the target frequency FREQ_target.

On the other hand, as illustrated by a dashed line, according to the voltage controlled oscillator VCO described with reference to FIG. 7, a noise component included in the output clock OCLK may be reduced (and/or minimized). For example, the frequency component distribution of the output clock OCLK generated by the voltage controlled oscillator VCO may have relatively small variance. For example, the output clock OCLK generated by the voltage controlled oscillator VCO may include a relatively large amount of frequency components corresponding to the target frequency FREQ_target, and may include a relatively small amount of frequency components not corresponding to the target frequency FREQ_target.

FIG. 9 is a graph illustrating a relationship between capacitance and a control voltage with respect to a variable capacitance circuit according to a bias voltage of FIG. 7. The horizontal axis of FIG. 9 represents a voltage level of a control voltage VCTRL, and the vertical axis represents a magnitude of capacitance with respect to the variable capacitance circuit VCC. Referring to FIG. 1, FIG. 2, and FIG. 6 to FIG. 9, the relationship between the voltage level of the control voltage VCTRL and capacitance CAP_VCC with respect to the variable capacitance circuit VCC may vary depending on the voltage level of the bias voltage VBIAS.

First, the relationship between the voltage level of the control voltage VCTRL and the capacitance CAP_VCC when the bias voltage VBIAS is the first voltage V1 is illustrated by a solid line. For example, as the control voltage VCTRL increases, the capacitance CAP_VCC may increase.

When the bias voltage VBIAS is the second voltage V2 higher than the first voltage V1, the relationship between the voltage level of the control voltage VCTRL and the capacitance CAP_VCC is illustrated by a dashed line. That is, when the bias voltage VBIAS is the second voltage V2 higher than the first voltage V1, the capacitance CAP_VCC may be determined based on the voltage level of the control voltage VCTRL which is relatively high. Similarly, when the bias voltage VBIAS is the third voltage V3 higher than the second voltage V2, the relationship between the voltage level of the control voltage VCTRL and the capacitance CAP_VCC is shown by a dash-dotted line.

That is, as the bias voltage VBIAS increases, the capacitance CAP_VCC may be determined based on a voltage level of the control voltage VCTRL which is relatively high. For example, for the same capacitance CAP_VCC, the higher the bias voltage VBIAS, the higher the control voltage VCTRL may be required. In contrast, when the same control voltage VCTRL is provided, the higher the bias voltage VBIAS, the smaller the capacitance CAP_VCC may be. For example, as the bias voltage VBIAS increases, the graphs of the bias voltage VBIAS and the capacitance CAP_VCC illustrated in FIG. 8 may move to the right direction. However, the scope of the present disclosure is not limited thereto.

FIG. 10 is a circuit diagram illustrating a configuration of the voltage controlled oscillator of FIG. 6 implemented according to some example embodiments. Referring to FIG. 1, FIG. 2 and FIG. 6 to FIG. 10, the voltage controlled oscillator VCO may include first and second drive transistors DT1 and DT2, an inductance tank circuit ITC, and a capacitance tank circuit CTC. The capacitance tank circuit CTC may be implemented as a capacitance tank circuit CTCd. Since the configurations and operations of the first and second drive transistors DT1 and DT2 and the inductance tank circuit ITC are similar to those described above, a detailed description thereof will be omitted.

The capacitance tank circuit CTCd may include a second inductor L2 and a plurality of variable capacitance circuits VCC. Each of the second inductor L2 and the plurality of variable capacitance circuits VCC may be connected between the first coupling node NCa and the second coupling node NCb. That is, the second inductor L2 and a plurality of variable capacitance circuits VCC may be connected in parallel between the first coupling node NCa and the second coupling node NCb. Since the configuration and operation of the second inductor L2 is similar to described above, detailed description will be omitted.

The capacitance tank circuit CTCd may include a plurality of variable capacitance circuits VCC that operate based on different bias voltages.

Hereinafter, for a more concise description, some example embodiments in which the capacitance tank circuit CTCd includes three variable capacitance circuits VCC will be described. For example, the capacitance tank circuit CTCd may include first to third variable capacitance circuits VCC1 to VCC3. However, the scope of the present disclosure is not limited to the number of variable capacitance circuits VCCs included in the capacitance tank circuit CTCd. For example, the capacitance tank circuit CTCd may include two or more variable capacitance circuits VCC.

The first variable capacitance circuit VCC1 may include a first varactor VR11 and a second varactor VR12. The first varactor VR11 may be connected between the first coupling node NCa and a first intermediate node NM1. The second varactor VR12 may be connected between the second coupling node NCb and the first intermediate node NM1. The first intermediate node NM1 may receive a first bias voltage VBIAS1. For example, the voltage level of the first bias voltage VBIAS1 may be the first voltage V1.

The second variable capacitance circuit VCC2 may include a first varactor VR21 and a second varactor VR22. The first varactor VR21 may be connected between the first coupling node NCa and a second intermediate node NM2. The second varactor VR22 may be connected between the second coupling node NCb and the second intermediate node NM2. The second intermediate node NM2 may receive a second bias voltage VBIAS2. For example, the voltage level of the second bias voltage VBIAS2 may be the second voltage V2.

Similarly, the third variable capacitance circuit VCC3 may include a first varactor VR31 and a second varactor VR32. The first varactor VR31 may be connected between the first coupling node NCa and a third intermediate node NM3. The second varactor VR32 may be connected between the second coupling node NCb and the third intermediate node NM3. The third intermediate node NM3 may receive a third bias voltage VBIAS3. For example, the voltage level of the third bias voltage VBIAS3 may be the third voltage V3.

The first voltage V1, the second voltage V2, and the third voltage V3 may be different from each other. For example, the second voltage V2 may be greater than the first voltage V1, and the third voltage V3 may be greater than the second voltage V2. For example, as described above with reference to FIG. 9, the relationship between capacitances of the first to third variable capacitance circuits VCC1 to VCC3 with respect to the control voltage VCTRL may be different from each other.

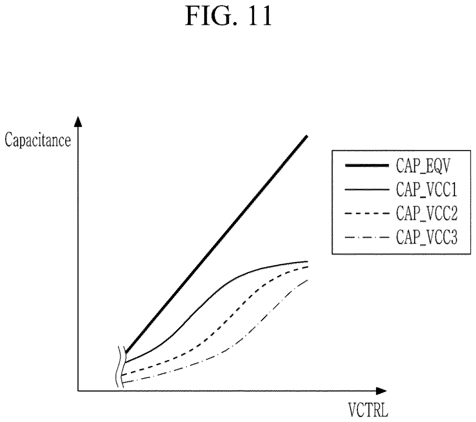

In some example embodiments, when the capacitance tank circuit CTCd includes a plurality of variable capacitance circuits VCC operating based on different bias voltages, the sum of capacitances of the plurality of variable capacitance circuits VCC may be linear with respect to the control voltage VCTRL. That is, when the capacitance tank circuit CTCd includes a plurality of variable capacitance circuits VCC operating based on different bias voltages, a relation between the capacitance of the capacitance tank circuit CTCd and control voltage VCTRL may be linear. The relationship between the capacitance and the control voltage VCTRL of the capacitance tank circuit CTCd will be described in more detail with reference to FIG. 11.

FIG. 11 is a graph illustrating a relationship between the capacitance of each of a plurality of variable capacitance circuits of FIG. 10 and the capacitance of the capacitance tank circuit. Referring to FIGS. 1, FIG. 2 and FIG. 6 to FIG. 11, the relationship between the voltage level of the control voltage VCTRL and the capacitance CAP_VCC of each of the plurality of variable capacitance circuits VCC may differ depending on the voltage level of the bias voltage VBIAS provided to each of the plurality of variable capacitance circuits VCC.

Hereinafter, for a more concise description, the capacitance CAP_VCC1 for the first variable capacitance circuit VCC1 is illustrated by a solid line, the capacitance CAP_VCC2 for the second variable capacitance circuit VCC2 is illustrated by a dashed line, and the capacitance CAP_VCC3 for the third variable capacitance circuit VCC3 is illustrated by a dash-dotted line.

The equivalent capacitance CAP_EQV between the first coupling node NCa and the second coupling node NCb may be determined based on the sum of the capacitance CAP_VCC1, the capacitance CAP_VCC2, and the capacitance CAP_VCC3. For example, as shown by a thick solid line, the equivalent capacitance CAP_EQV may linearly increase in response to the control voltage VCTRL increasing. For example, the capacitance of the capacitance tank circuit CTC viewed from the first output node Nout1 and the second output node Nout2 may also increase linearly in response to the control voltage VCTRL.

That is, according to some example embodiments of the present disclosure, even if the first and second resistors R1 and R2 and the first and second cut-off capacitors CC1 and CC2 described above with reference to FIG. 5 are not included, the capacitance of the capacitance tank circuit CTC may increase linearly in response to the control voltage VCTRL. For example, thermal noise generated by the first and second resistors R1 and R2 may not be included in the output clock OCLK, and the frequency magnitude variation range limitation of the output clock OCLK with respect to the control voltage VCTRL by the first and second cut-off capacitors CC1 and CC2 may not occur.

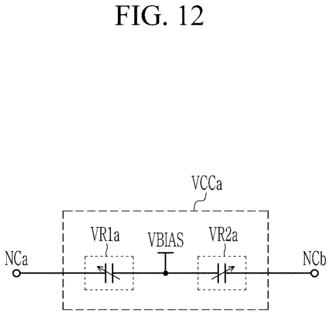

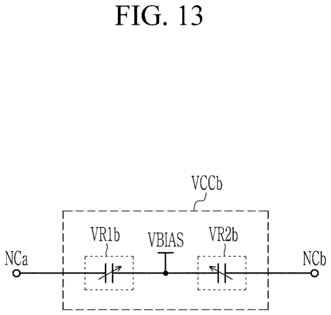

FIG. 12 and FIG. 13 are circuit diagrams illustrating a variable capacitance circuit of FIG. 7 or FIG. 10 according to some example embodiments in more detail.

First, referring to FIG. 1, FIG. 2 and FIG. 6 to FIG. 12, the variable capacitance circuit VCC illustrated in FIG. 7 or FIG. 10 may be implemented as a variable capacitance circuit VCCa.

The variable capacitance circuit VCCa may include a first varactor VR1a and a second varactor VR2a. The anode terminals of the first varactor VR1a and the second varactor VR2a may be connected to the intermediate node NM. The cathode terminal of the first varactor VR1a may be connected to the first coupling node NCa, and the cathode terminal of the second varactor VR2a may be connected to the second coupling node NCb.

On the other hand, referring to FIG. 1 and FIG. 6 to FIG. 13, the variable capacitance circuit VCC illustrated in FIG. 7 or FIG. 10 may be implemented as a variable capacitance circuit VCCb.

The variable capacitance circuit VCCb may include a first varactor VR1b and a second varactor VR2b. Cathode terminals of the first varactor VR1b and the second varactor VR2b may be connected to the intermediate node NM. The anode terminal of the first varactor VR1b may be connected to the first coupling node NCa, and the anode terminal of the second varactor VR2b may be connected to the second coupling node NCb.

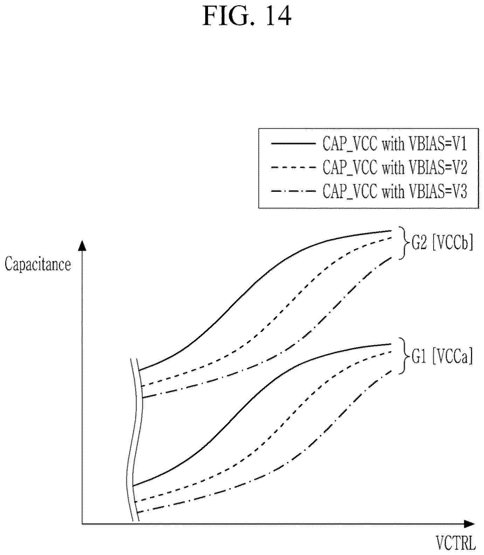

FIG. 14 is a diagram illustrating a relationship between the capacitance and the control voltage of variable capacitance circuits of FIG. 12 and FIG. 13. The horizontal axis of FIG. 14 represents a voltage level of a control voltage VCTRL, and the vertical axis represents a size of capacitance.

The first graph group G1 shows a relationship between the capacitance of the variable capacitance circuit VCCa and the control voltage VCTRL described above with reference to FIG. 12. Among the first graph groups G1, a graph illustrated by a solid line, a graph illustrated by a dashed line, and a graph illustrated by a dash-dotted line may indicate a relationship between the control voltage VCTRL and the capacitance CAP_VCC with respect to the variable capacitance circuit VCCa when the bias voltage VBIAS is the first to third voltages V1-V3, respectively.

The second graph group G2 shows a relationship between the capacitance and the control voltage VCTRL of the variable capacitance circuit VCCb described above with reference to FIG. 13. Among the second graph groups G2, a graph illustrated by a solid line, a graph illustrated by a dashed line, and a graph illustrated by a dash-dotted line may indicate a relationship between the control voltage VCTRL and the capacitance CAP_VCC with respect to the variable capacitance circuit VCCb when the bias voltage VBIAS is the first to third voltages V1-V3, respectively.

That is, referring to FIG. 12 to FIG. 14, the relationship between the control voltage VCTRL and the capacitance of the variable capacitance circuit VCC may vary depending on the direction (e.g. polarity) of the varactor VR included in the variable capacitance circuit VCC. For example, the capacitance of the variable capacitance circuit VCCa may have a smaller value than that of the variable capacitance circuit VCCb. For example, when a control voltage VCTRL of the same magnitude is provided, the capacitance of the variable capacitance circuit VCCa may be smaller than that of the variable capacitance circuit VCCb.

The quality factor QF_CTC of the capacitance tank circuit CTC may be proportional to the reciprocal of the capacitance of the capacitance tank circuit CTC. Accordingly, the quality factor QF_CTC of the capacitance tank circuit CTC including the variable capacitance circuit VCCa may be greater than the quality factor QF_CTC of the capacitance tank circuit including the variable capacitance circuit VCCb. That is, when the variable capacitance circuit VCC included in the capacitance tank circuit CTC is implemented as the variable capacitance circuit VCCa, the quality factor of the capacitance tank circuit CTC may increase. For example, the phase noise included in the output clock OCLK may be reduced (and/or minimized). Therefore, according to the embodiment of FIG. 12, similar to what is previously described with reference to FIG. 8, the frequency component distribution included in the output clock OCLK may be similar to the frequency component distribution of the output clock OCLK generated by the ideal voltage controlled oscillator VCO.

In some example embodiments, due to the structure of the silicon oxide layer and the depletion layer included in the varactor VR, the capacitance of the varactor VR viewed from the gate terminal (e.g., the anode terminal) side may be different from the capacitance of the varactor VR viewed from the source terminal (e.g., the cathode terminal). Due to such configuration of the varactor VR, a relationship between the control voltage VCTRL and the capacitance of the variable capacitance circuit VCC may occur according to the direction of the varactor VR included in the variable capacitance circuit VCC. However, the scope of the present disclosure is not limited to the specific cause of the change in the relationship between the control voltage VCTRL and the capacitance of the variable capacitance circuit VCC according to the direction of the varactor VR included in the variable capacitance circuit VCC.

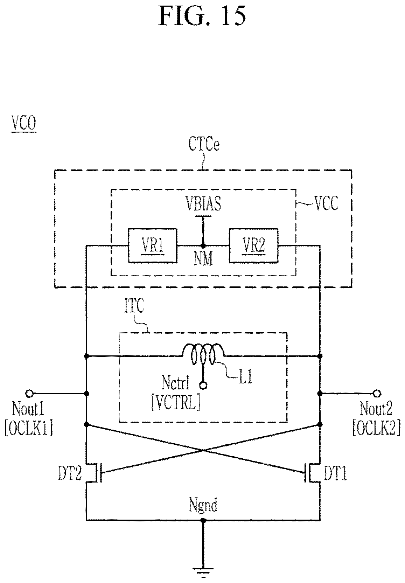

FIG. 15 illustrates a voltage controlled oscillator of FIG. 1 implemented according to some example embodiments. Referring to FIGS. 1 and 15, the voltage controlled oscillator VCO may include first and second drive transistors DT1 and DT2, an inductance tank circuit ITC, and a capacitance tank circuit CTC. The capacitance tank circuit CTC may be implemented as a capacitance tank circuit CTCe. Since the configurations and operations of the first and second drive transistors DT1 and DT2 are similar to those described above, a detailed description thereof will be omitted.

The inductance tank circuit ITC may include a first inductor L1. The first inductor L1 may be connected between the first output node Nout1 and the second output node Nout2.

The first inductor L1 may include a first center tap node connected to the control node Nctrl. That is, the first inductor L1 may receive the control voltage VCTRL through the first center tap node.

The capacitance tank circuit CTCe may be connected between the first output node Nout1 and the second output node Nout2. The capacitance tank circuit CTCe may include a variable capacitance circuit VCC. Since the configuration and operation of the variable capacitance circuit VCC are similar to those described above, a detailed description thereof will be omitted.

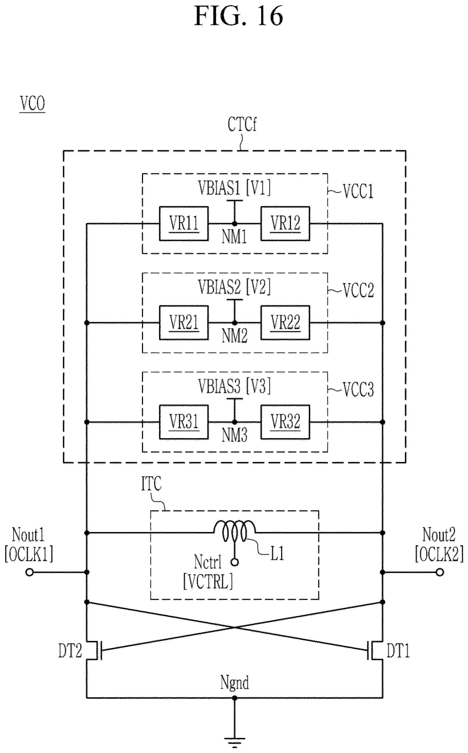

FIG. 16 illustrates a voltage controlled oscillator of FIG. 1 implemented according to some example embodiments. Referring to FIG. 1, FIG. 15,and FIG. 16, the voltage controlled oscillator VCO may include first and second drive transistors DT1 and DT2, an inductance tank circuit ITC, and a capacitance tank circuit CTC. The capacitance tank circuit CTC may be implemented as a capacitance tank circuit CTCf. Since the configurations and operations of the first and second drive transistors DT1 and DT2 and the inductance tank circuit ITC are similar to those described above, a detailed description thereof will be omitted.

The capacitance tank circuit CTCf may include a plurality of variable capacitance circuits VCC. Each of the plurality of variable capacitance circuits VCC may be connected between the first output node Nout1 and the second output node Nout2. That is, a plurality of variable capacitance circuits VCC may be connected in parallel between the first output node Nout1 and the second output node Nout2.

The capacitance tank circuit CTCf may include a plurality of variable capacitance circuits VCC that operate based on different bias voltages. For example, the capacitance tank circuit CTCd may include first to third variable capacitance circuits VCC1 to VCC3. Since configurations and operations of the first to third variable capacitance circuits VCC1 to VCC3 are similar to those described with reference to FIG. 10, a detailed description thereof will be omitted.

In some example embodiments, when the capacitance tank circuit CTCf includes a plurality of variable capacitance circuits VCC operating based on different bias voltages, the sum of capacitances of the plurality of variable capacitance circuits VCC may be linear with respect to the control voltage VCTRL. For example, the relationship between the capacitance of the capacitance tank circuit CTCf and the control voltage VCTRL may be similar to that described with reference to FIG. 11.

One or more of the elements disclosed above may include or be implemented in processing circuitry such as hardware including logic circuits; a hardware/software combination such as a processor executing software; or a combination thereof. For example, the processing circuitry may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, an application-specific integrated circuit (ASIC), etc.

Embodiments are set out in the following Clauses:
Clause 1. A voltage controlled oscillator configured to receive a control voltage and output first and second output clocks having frequency corresponding to a magnitude of the control voltage, the voltage controlled oscillator comprising:
   a first drive transistor including a first gate terminal connected to a first output node through which the first output clock is output, the first drive transistor being connected between a second output node and a ground node;
   a second drive transistor connected between the first output node and the ground node, the second drive transistor including a second gate terminal connected to the second output node through which the second output clock is output;
   an inductance tank circuit connected between the first output node and the second output node; and
   a capacitance tank circuit configured to be inductively coupled to the inductance tank circuit, the capacitance tank circuit being configured to operate based on a control voltage that is externally provided.
Clause 2. The voltage controlled oscillator of Clause 1, wherein the capacitance tank circuit is electrically separated from the first output node and the second output node.
Clause 3. The voltage controlled oscillator of Clause 1 or Clause 2, wherein
   the inductance tank circuit comprises a first inductor connected between the first output node and the second output node, and
   the capacitance tank circuit comprises a second inductor connected between a first coupling node and a second coupling node,
   wherein the second inductor is inductively coupled to the first inductor.
Clause 4. The voltage controlled oscillator of Clause 3, wherein
   the capacitance tank circuit further comprises a first variable capacitance circuit connected between the first coupling node and the second coupling node, the first variable capacitance circuit being connected in parallel to the second inductor, and
   the first variable capacitance circuit comprises:
      a first varactor connected between the first coupling node and a first intermediate node; and
      a second varactor connected between the second coupling node and the first intermediate node.
Clause 5. The voltage controlled oscillator of Clause 4, wherein
   the capacitance tank circuit further comprises a second variable capacitance circuit connected between the first coupling node and the second coupling node, the second variable capacitance circuit being connected in parallel to the second inductor and being connected in parallel to the first variable capacitance circuit, and
   the second variable capacitance circuit comprises:
      a third varactor connected between the first coupling node and a second intermediate node; and
      a fourth varactor connected between the second coupling node and the second intermediate node.
Clause 6. The voltage controlled oscillator of Clause 5, wherein:
   the first intermediate node and the second intermediate node are configured to receive bias voltages having different levels with respect to each other.
Clause 7. The voltage controlled oscillator of any of Clauses 4-6, wherein
   the first varactor comprises a first anode terminal and a first cathode terminal,
   the second varactor comprises a second anode terminal and a second cathode terminal,
   the first anode terminal and the second anode terminal are connected to the first intermediate node,
   the first cathode terminal is connected to the first coupling node, and
   the second cathode terminal is connected to the second coupling node.
Clause 8. The voltage controlled oscillator of any of Clause 3-7, wherein
   the first inductor is configured to receive a power supply voltage through a first center tap node included in the first inductor, and
   the second inductor is configured to receive the control voltage through a second center tap node included in the second inductor.

The above are specific embodiments for implementing the present disclosure. The present disclosure will include not only the above-described embodiments, but also embodiments that may be simply designed or easily changed. The present disclosure will also include technologies that may be easily modified and implemented using embodiments. Therefore, the scope of this disclosure should not be limited to the above-described embodiments, but should be determined not only by the scope of the claims to be described below but also by those equivalent to the scope of the claims of this disclosure.

## Claims

1. A voltage controlled oscillator comprising:
a first drive transistor including a first gate terminal connected to a first output node, the first drive transistor being connected between a second output node and a ground node;
a second drive transistor connected between the first output node and the ground node, the second drive transistor including a second gate terminal connected to the second output node;
a first inductor connected between the first output node and the second output node;
a second inductor connected in parallel between a first coupling node and a second coupling node; and
a first variable capacitance circuit connected in parallel between the first coupling node and the second coupling node,
wherein the second inductor is configured to receive a control voltage and is inductively coupled to the first inductor.

2. The voltage controlled oscillator of claim 1, wherein the first inductor is configured to receive a power supply voltage through a center tap node included in the first inductor.

3. The voltage controlled oscillator of claim 1 or claim 2, wherein the second inductor is configured to receive the control voltage through a center tap node included in the second inductor.

4. The voltage controlled oscillator of any preceding claim, wherein the first variable capacitance circuit comprises:
a first varactor connected between the first coupling node and a first intermediate node; and
a second varactor connected between the second coupling node and the first intermediate node, and
wherein the first intermediate node is configured to receive a first bias voltage.

5. The voltage controlled oscillator of claim 4, wherein the first output node and the second output node are configured to respectively output a first output clock and a second output clock having a same frequency and opposite phase with respect to each other.

6. The voltage controlled oscillator of claim 5, wherein
the frequency is based on capacitance of the first variable capacitance circuit.

7. The voltage controlled oscillator of claim 6, wherein:
the capacitance of the first variable capacitance circuit is based on the control voltage and the bias voltage.

8. The voltage controlled oscillator of any of claims 4-7, wherein
the first varactor comprises a first anode terminal and a first cathode terminal,
the second varactor comprises a second anode terminal and a second cathode terminal,
the first anode terminal and the second anode terminal are connected to the first intermediate node,
the first cathode terminal is connected to the first coupling node, and
the second cathode terminal is connected to the second coupling node.

9. The voltage controlled oscillator of any of claims 4-8, further comprising a second variable capacitance circuit connected in parallel to the second inductor and the first variable capacitance circuit, the second variable capacitance circuit being connected between the first coupling node and the second coupling node.

10. The voltage controlled oscillator of claim 9, wherein the second variable capacitance circuit comprises:
a third varactor connected between the first coupling node and a second intermediate node; and
a fourth varactor connected between the second coupling node and the second intermediate node, and
wherein the second intermediate node is configured to receive a second bias voltage different from the first bias voltage.

11. A phase locked loop comprising:
a voltage controlled oscillator configured to generate a first output clock and a second output clock based on a control voltage;
a frequency divider configured to generate a feedback clock based on the first output clock and the second output clock;
a phase frequency detector configured to generate a difference signal based on a difference between the feedback clock and a reference clock that is externally provided; and
a control voltage generator configured to adjust a level of the control voltage based on the difference signal,
wherein the voltage controlled oscillator comprises
a first inductor connected between a first output node outputting the first output clock and a second output node outputting the second output clock,
a second inductor connected between a first coupling node and a second coupling node, the first coupling node and the second coupling node being electrically separated from the first and second output nodes, and the second inductor being configured to receive the control voltage and being inductively coupled to the first inductor,
a first varactor connected between the first coupling node and a first intermediate node that is configured to receive a first bias voltage, and
a second varactor connected between the second coupling node and the first intermediate node.

12. The phase locked loop of claim 11, wherein the voltage controlled oscillator further comprises:
a third varactor connected between the first coupling node and a second intermediate node configured to receive a second bias voltage; and
a fourth varactor connected between the second coupling node and the second intermediate node.

13. The phase locked loop of claim 11 or claim 12, wherein:
the first varactor comprises a first anode terminal and a first cathode terminal,
the second varactor comprises a second anode terminal and a second cathode terminal,
the first anode terminal and the second anode terminal are connected to the first intermediate node,
the first cathode terminal is connected to the first coupling node, and
the second cathode terminal is connected to the second coupling node.

14. The phase locked loop of any of claims 11-13, wherein the voltage controlled oscillator further comprises:
a first drive transistor including a first gate terminal connected to the first output node, the first drive transistor being connected between the second output node and a ground node;
a second drive transistor including a second gate terminal connected to the second output node, the second drive transistor being connected between the first output node and the ground node.

15. The phase locked loop of any of claims 11-14, wherein the second inductor is configured to receive the control voltage through a center tap node included in the second inductor.
